# EUROPEAN PATENT SPECIFICATION

(11) **EP 0 577 128 B1**
(45) Date of publication and mention of the grant of the patent: **16.10.1996**
(21) Application number: 93110535.7
(22) Date of filing: 01.07.1993
(51) Int. Cl.: H05K 13/08, H01L 21/00

(54) **Method for mounting components and an apparatus therefor**
Verfahren zum Montieren von Bauteilen und Vorrichtung dafür
Procédé de montage de composants et dispositif de mise en oeuvre

(30) Priority: 01.07.1992 JP 173571/92
(43) Date of publication of application: 05.01.1994
(73) Proprietor: YAMAHA HATSUDOKI KABUSHIKI KAISHA, Iwata-shi Shizuoka-ken, 438 (JP)
(72) Inventor: Sakurai, Hiroshi, Hamamatsu-shi, Shizuoaka-ken (JP); Ohta, Hiroyuki, Hamamatsu-shi, Sizuoka-ken (JP); Onodera, Hitoshi, Iwata-shi, Shizuoaka-ken (JP)
(74) Representative: Grünecker, Kinkeldey, Stockmair & Schwanhäusser Anwaltssozietät

(56) References cited:
- EP-A- 0 144 717
- EP-A- 0 374 848

## Description

The present invention relates to a method for mounting a component at a specific position, preferably on a substrate such as a printed circuit board, as indicated in the preamble of claim 1. Moreover, the present invention relates to an mounting apparatus for such a component, preferably for performing the afore-indicated method.

For mounting minute components such as ICs, resistors, condensers, etc., exactly on their specified positions on a substrate, a mounting apparatus was already suggested which attracts a component through an attracting nozzle by vacuum detecting the attracting position of the component in view of irregularities which can prevent the component from being precisely positioned on the desired spot onto the substrate. Moreover, it has been deliberated to try to balance displacements of the attracting point of the component in different directons relative to the centre of the component in order to introduce such data into the control means for precisely positioning the component.

For example, a mounting method and apparatus of the type indicated above have been proposed in EP-A-0 144 717, wherein the position of a component relative to the pick up means is detected by means of a laser detection means. A plurality of correction values are provided so as to correct the displacement and the mounting position of the pick up means.

Difficulties have arisen in as far as such measurements aiming to acquire correcting values for improving the mounting accuracy considerably increase the cycle time of the assembling process, lowering the efficiency of the mounting procedure.

Accordingly, it is an objective of the present invention to provide a method of the type as indicated above enabling to consider not only an appropriate general attracting position of the component in the process of being mounted but also efficiently detecting the relative attracting position of the component in order to derive correcting values which can be introduced into the control of the movement of the mounting head to increase the assembling accuracy without drastically reducing the efficiency of the mounting process.

Moreover, it is another objective of the present invention to provide an apparatus for mounting a component at a specific position, preferably on a substrate such as a printed circuit board, comprising a movable mounting head unit which facilitates the mounting operation, preferably adapted to perform the afore-indicated method.

According to the present invention, this objective concerning the method aspects is performed by the method as defined in Claim 1. Thus, by the detection of the projection width of the component, a normal attracting position of the component is discriminated and a correcting amount with respect to the other longitudinal position in the direction of the other axis is obtained by calculation using data obtained by said detection.

In this way, since either of the X-direction and Y-direction correction amounts of the mounting position are obtained by calculation, the extra time necessary for actual measurements is reduced, the time required for positioning the component and mounting same on a substrate such as a printed circuit board is shortened and thus the component mounting efficiency is improved.

According to the present invention, the aforeindicated objective concerning the apparatus aspects is performed by the apparatus as defined in Claim 5. Thus, a processing means is provided for calculating another mounting position correcting amount of the components mounting position with respect to the other longitudinal position of the component in the direction of the other axis on the basis of said data provided by said detecting means.

Preferred embodiments of the present invention are laid down in the further sub-claims.

In the following the present invention is explained in greater detail hereinafter by means of a preferred embodiment thereof in conjunction with the accompanying drawings wherein:
Figure 1 is an apparatus for mounting a component according to a preferred embodiment of the present invention,
Figure 2 is a front view of a mounting head unit of the apparatus of Figure 1,
Figure 3 is a block diagram of the components and control means of the apparatus of Figure 1,
Figure 4 is a flow chart showing the method for mounting the component according to a preferred embodiment of the present invention by the apparatus of Figure 1,
Figure 5 is an explanatory table showing the vertical movement (Z-axis) and the rotating movement (R-axis) of the component at each step of the mounting procedure,
Figure 6 is a plan view showing the movement path of the mounting head unit with the attracting nozzle corresponding to Figure 5,
Figures 7a through 7c are explanatory illustrations showing the method for detecting a minimum projection width of the component,
Figure 8 is a diagram showing the change in projection width of the component in response to it's angle of rotation,
Figure 9 is an explanatory illustration for deriving the equations of calculation of the correcting amount (X_{c}) for for the X-axis direction, and
Figures 10a through 10c are illustrations showing various (normal and irregular) attracting conditions of the component.

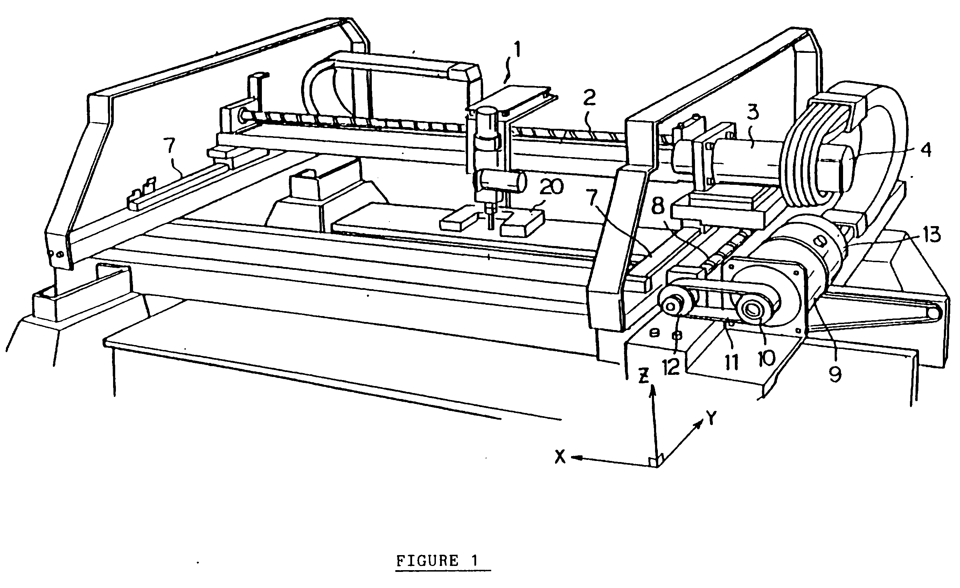

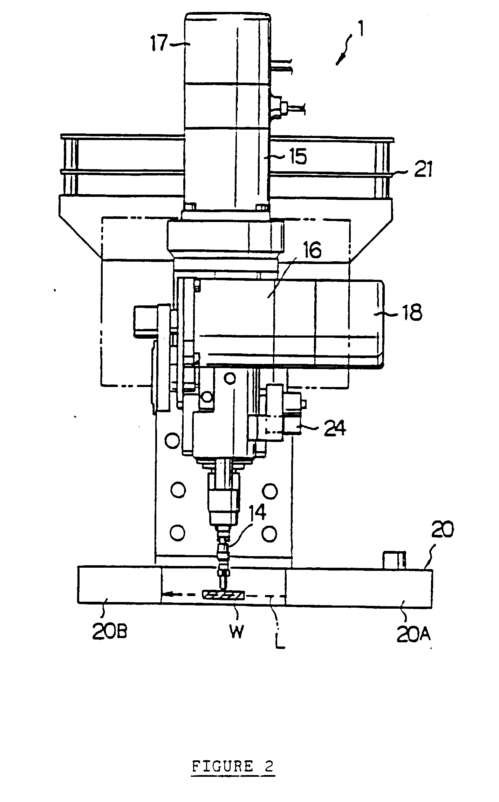

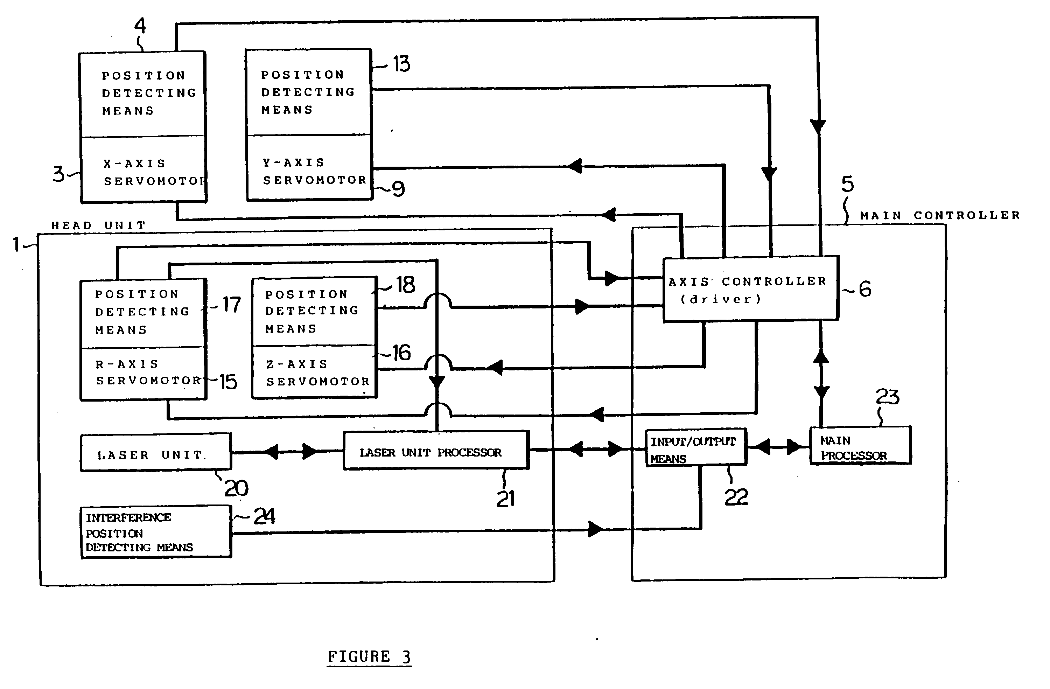

First is described the basic structure of the component mounting apparatus according to this invention referring to Figures 1 through 3. Figure 1 is a perspective view of a component mounting apparatus according to this invention, Figure 2 is a front view of a head unit equipped on the component mounting apparatus above, and Figure 3 is a block diagram showing the structure of the component mounting apparatus above.

The component mounting apparatus according to this invention is provided with a head unit 1 which is movable in the X-Y-plane as shown in Fig. 1.

The head unit 1 is movably engaged with a ball screw 2 rotatably disposed along the X-axis, and is moved in the X-axis direction on the ball screw 2 by the rotation of the ball screw 2 caused by an X-axis servomotor 3. The servomotor 3 is provided with a position detecting means 4 therefore, and the servomotor 3 and the detecting means 4 are electrically connected with the axis controller (driver) 6 of the main controller 5 as shown in Fig. 3.

The ball screw 2 and the X-axis servomotor 3 are supported for movement in the Y-axis direction along a pair of rails 7 installed in parallel to each other, and these are movably engaged with a ball screw 8 rotatably disposed along the Y-axis direction. When the Y-axis servomotor 9 is actuated, its rotation is transmitted to the ball screw 8 through a pulley 10, belt 11 and pulley 12. Then the ball screw 2, X-axis servomotor 3 and head unit 1 are moved in the Y-axis direction along the ball screw 8. The Y-axis servomotor 9 is provided with a position detecting means 13 therefore, and the servomotor 9 and the detecting means 13 are electrically connected with the axis controller (driver) 6 of the main controller 5 as shown in Fig. 3.

Therefore, when the ball screws 2 and 8 are rotated by the X-axis servomotor 3 and by the Y-axis servomotor 9, respectively, the head unit 1 can move to an arbitrary position in the X-Y-plane as described before.

Here is described the structure of the head unit 1 referring to Fig. 2.

The reference numeral 14 denotes an attracting nozzle for attracting the component K through vacuum, and the attracting nozzle 14 can be both rotated about its center axis (R-axis) by the R-axis servomotor 15 and moved up or down in the Z-axis direction by the Z-axis servomotor 16. The R-axis servomotor 15 and the Z-axis servomotor 16 are provided with a position detecting means 17 and 18, respectively, and these sets of servomotors and position detectors (15 and 17) and (16 and 18) are electrically connected with the axis controller (driver) 6 of the main controller 5 as shown in Fig. 3.

On the lower end of the head unit 1 is installed a laser unit 20, an optical detecting means, having a laser generator 20A and a detector (CCD) 20B disposed opposite to each other on both sides of the attracting nozzle 14. The laser unit 20 is electrically connected with the laser unit processor 21, which is in turn connected with the main processor 23 through the input-output means 22 of the main controller 5. In addition, the position detecting means 17 is connected with the laser unit 20.

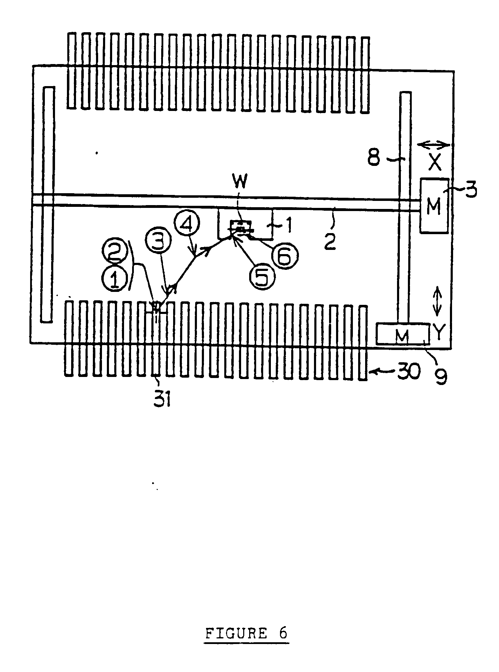

Further, the head unit 1 is provided with an interference position detecting means 24 for detecting the position of interference of the component supplying unit 30 to be described later (see Fig. 6) and the attracting nozzle 14, and the interference position detecting means 24 is connected with the input-output means 22 of the main controller 5.

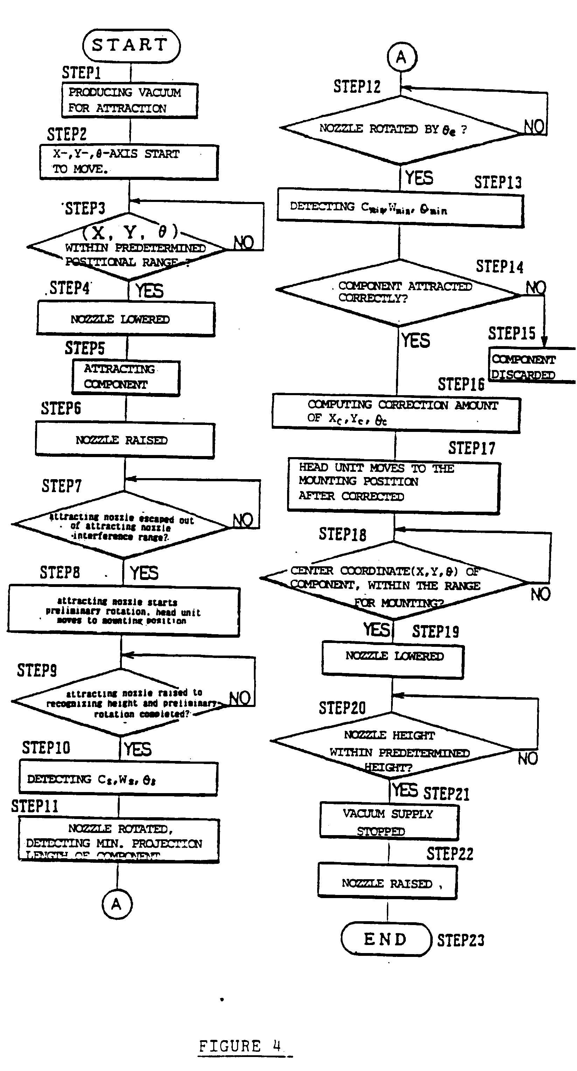

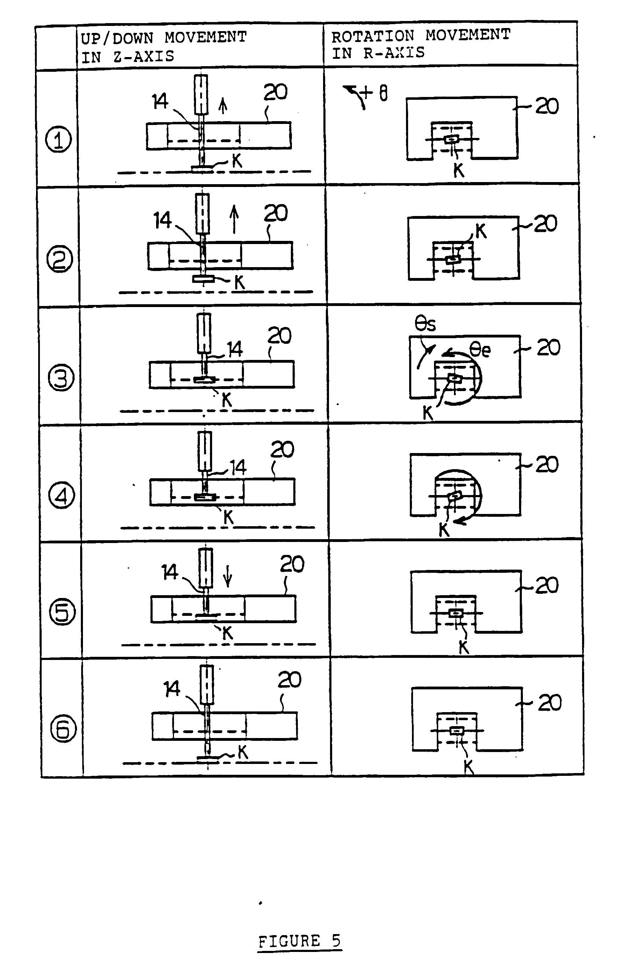

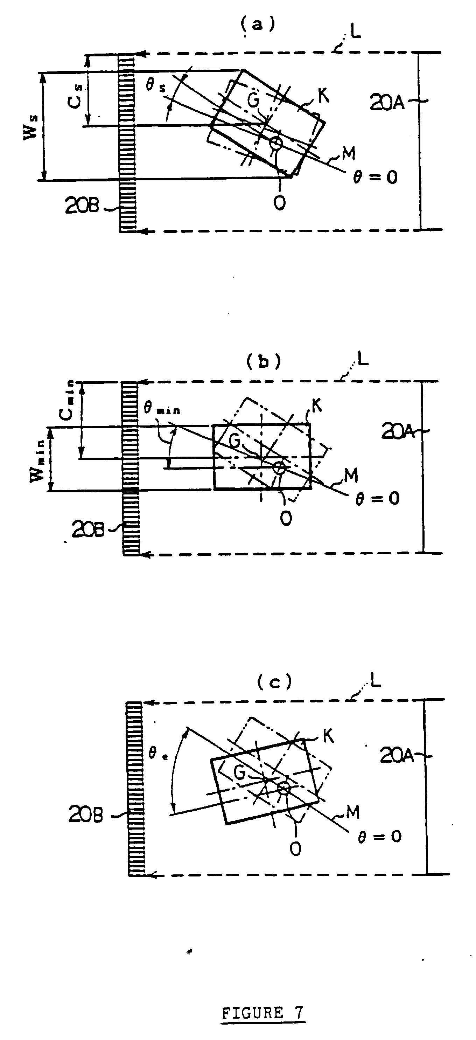

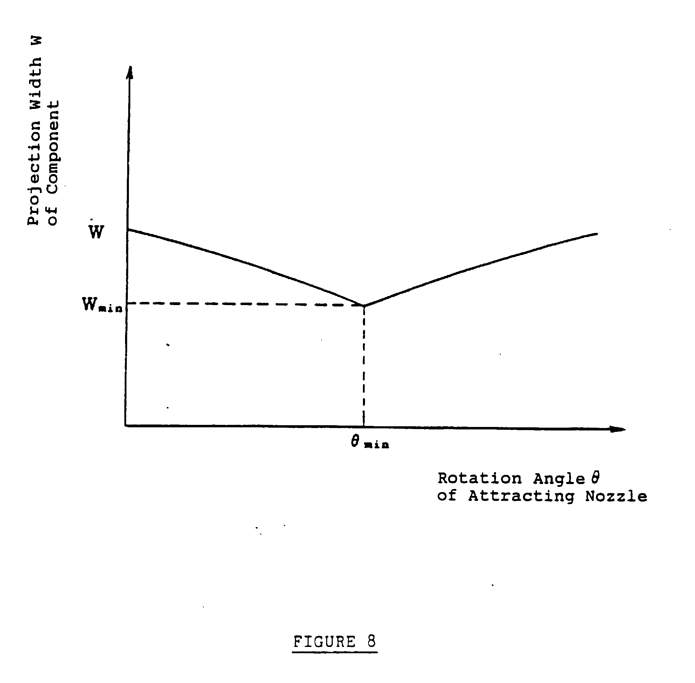

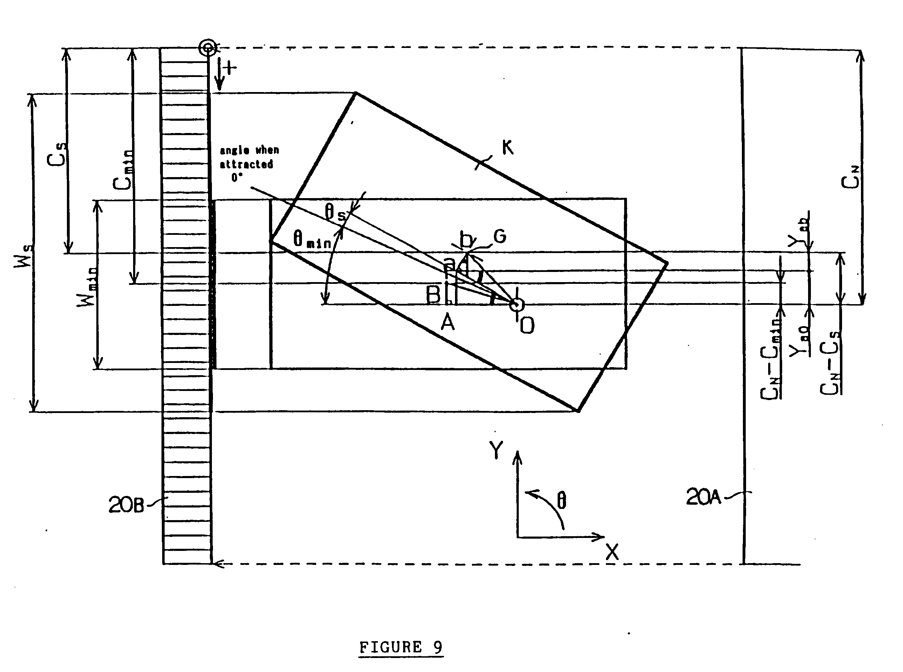

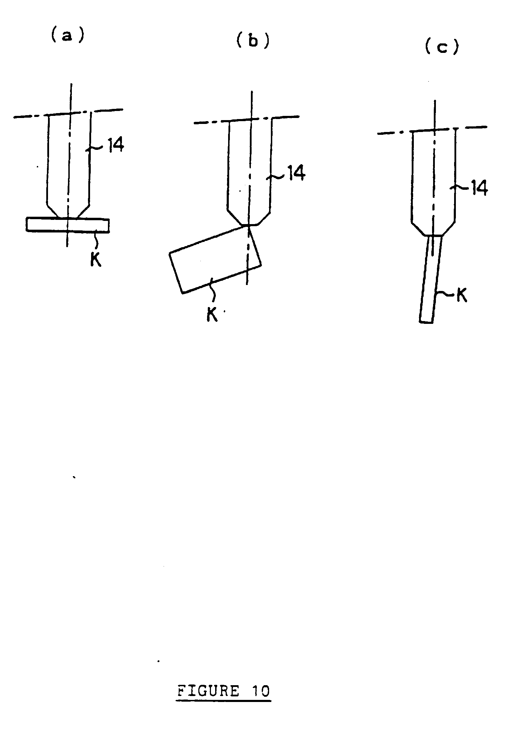

Next are described the method and procedure for mounting a component K using this component mounting apparatus referring to Figs. 4 through 9. Fig. 4 is a flow chart showing the component mounting procedure. Fig. 5 is an explanatory table showing the Z-axis (up-down) movement and the R-axis (rotating) movement at each step. Fig. 6 corresponding to Fig. 5 is a plan view showing the movement of the head unit (attracting nozzle). Figs. 7(a) through 7(c) are explanatory illustrations showing the method for detecting the minimum width of projection. Fig. 8 is a diagram showing the change in projection width of the component versus its rotation angle. Fig. 9 is an explanatory illustration for deriving the calculating equation of the X-direction mounting position correction amount X_{c}. Figs. 10(a) through 10(c) are illustrations showing the various attracted states of the component.

When attracting the component K, first is produced an attractig vacuum in the attracting nozzle 14 (step 1 in Fig. 4), then the X-axis, Y-axis and R-axis servomotors 3, 9 and 15 are actuated so that the head unit 1 may be moved in the X-Y-plane to the position above the specified feeder 31 of the component supplying unit 30 (component attracting position) and the attracting nozzle may be rotated (step 2 in Fig. 4.). Here, if the coordinates of the center of the attracting nozzle 14 comes in the allowable range of the predetermined position (component attracting position) (step 3 in Fig. 4), the Z-axis servomotor 16 is actuated to lower the attracting nozzle 14 in the Z-axis direction (step 4 in Fig. 4), and the component K contained in the feeder 31 is attracted by the attracting nozzle 14 (step 5 in Fig. 4, 1 in Figs.5 and 6). Points 1 - 6 shown in Fig. 6 show the positions of the center of the attracting nozzle 14 in the corresponding states 1 - 6 in Fig. 5.

When the component K is attracted by the attracting nozzle 14 as described above, the Z-axis servomotor 16 is again actuated and the attracting nozzle 14 is raised along the Z-axis (step 6 in Fig. 4), and then, when it is confirmed, by the interference position detecting means 24, that the attracting nozzle 14 has escaped from the range of interference with the feeder 31 (step 7 in Fig. 4), the X-axis and Y-axis servomotors 3 and 9 are actuated and the head unit 1 is moved in the X-Y-plane toward the component mounting position (step 8 in Fig. 4, 2 in Figs. 5 and 6). The distances of movements of the head unit 1 (attracting nozzle 14) in the X-axis and Y-axis directions and the angle of rotation θ of the attracting nozzle 14 about the R-axis are detected by the position detecting means 4, 13 and 17, respectively, and are fed back to the axis controller 6 of the main controller 5, and the axis controller 6 controls the actuation of the respective servomotors 3, 9 and 15 on the basis of the data fed back.

Then, when the attracting nozzle 14 reaches the recognizing height at which the laser unit 20 can recognize the component (step 9 in Fig. 4), the laser unit 20 starts detecting the component K (step 10 in Fig 4, 3 in Figs. 5 and 6).

Here is described the method for detecting the component K by the laser unit 20 referring to Figs 7(a), 7(b) and 7(c). When the component K is attracted as shown in chain line Fig. 7(a), the attracted point of the component (corresponding to the center point of the attracting nozzle 14 is taken as O, and the line M passing through the attracted point O in parallel to the longer side of the component K is taken as the rotation starting line (θ = O) of the attracting nozzle 14.

The R-axis servomotor 15 is actuated with the component K attracted on the attracting nozzle 14, and rotates the attracting nozzle 14 clockwise by an angle θₛ, thus the component K is rotated in the same sense by the same angle θₛ about the attracted point O from the chain line position to the solid line position shown in Fig. 7(a) (This is called "preliminary rotation"). This preliminary rotation is practiced to securely produce the state of the component K in which its projection width W on the Y-axis becomes minimum (state shown in Fig. 7(b)).

Here, a laser beam L is emitted in parallel to the X-axis from the laser generator 20A of the laser unit 20 while the component K is in a state shown in solid lines in Fig. 7(a). Since the light intensity of the laser beam L is lower in the portion of the detector 20B corresponding to the projection width (Wₛ) of the component K on the detector 20B (Y-axis) because the laser beam L is intercepted by the component K. The projection width Wₛ of the component K on the Y-axis is detected by the detector 20B. At the same time, the center position Cₛ of of the projection width Wₛ of the component K and the rotation angle θₛ of the attracting nozzle 14 are also detected, and these values Wₛ, Cₛ and θₛ are fed to the main processor 23 of the main controller 5 through the laser unit processor 21 and the input-output means 22 of the main controller 5.

When the detections above are completed, the R-axis servomotor 15 is actuated, the attracting nozzle 14 is rotated counterclockwise by a specified angle θₑ (e.g., 45^{o}), the component K is also rotated about the attracted point O from its chain line position in Fig. 7(a) to its solid line position in Fig. 7(c) as shown in Fig 7(c), and, during this rotation, the projection width W of the component K on the Y-axis is detected by the laser unit 20 (step 11 and 12 in Fig. 4).

If the projection width W of the component K on the Y-axis is detected by the laser unit 20 while rotating the component K as described above, the projection width W first decreases gradually with the increase in the rotation angle θ as shown in Fig. 8, and reaches its minimum in the state of the component K shown in Fig. 7(b) (the state in which the longer side of the component K becomes parallel to the X-axis).

In the state described above, the minimum projection width Wₘᵢₙ of the component K, the center position Cₘᵢₙ of the projection width Wₘᵢₙ and the rotation angle θₘᵢₙ of the attracting nozzle 14 are detected (step 13 in Fig. 4), and these values Wₘᵢₙ, Cₘᵢₙ and θₘᵢₙ are fed to the main processor 23 of the main controller 5 through the laser unit processor 21 and the input-output means 22 of the main controller 5.

Thereafter, the main processor 23 of the main controller 5 judges whether the component K is normally attracted as shown in Fig. 10(a), or is attracted in an abnormal (rather upright) state as shown in Fig. 10(b) or Fig 10(c) using the input data θₛ, θₑ, Wₘᵢₙ and θₘᵢₙ (step 14 in Fig. 4), and, if the component K is not attracted normally, the component K is discarded (step 15 in Fig. 4).

When it is confirmed that the component K is normally attracted, the main processor 23 of the main controller 5 calculates the component mounting position correction amounts X_{c}, Y_{c} and θ_{c} in the X, Y and θ directions (step 16 in Fig. 4).

Among the correction amounts X_{c}, Y_{c} and θ_{c} above, correction amounts Y_{c} and θ_{c} in the Y and θ directions are calculated, using the following equations:${\text{Y}}_{\text{c}} {\text{= C}}_{\text{min}} {\text{- C}}_{\text{N}}$${\text{θ}}_{\text{c}} {\text{= θ}}_{\text{min}}$

In the equation (1), C_{N} is the center position (attracting point) of the attracting nozzle 14 as shown in Fig. 9, and, since this is a known value, the correction amounts Y_{c} and θ_{c} are values obtainable substantially by actual measurement.

The X-direction correction amount X_{c} is therefore obtained by calculations using data Cₛ, θₛ, Cₘᵢₙ and θₘᵢₙ obtained by detections. The equation for these calculations, are derived as follows referring to Fig. 9.

In Fig. 9, Δ AOB ≡ Δ aOb, and, because$\overline{\text{a b}} \text{=} \overline{\text{A B}} {\text{= C}}_{\text{N}} {\text{- C}}_{\text{min}}$ the projection length Y_{ab} of the side $\overline{\text{a b}}$ on the Y-axis is obtained from the following equation:${\text{Y}}_{\text{ab}} {\text{= (C}}_{\text{N}} {\text{- C}}_{\text{min}} {\text{)·COS (θ}}_{\text{min}} {\text{+ θ}}_{\text{s}} \text{)}$

Similarly, the projection length Yₐₒ of the side $\overline{\text{a o}}$ on the Y-axis is obtained by the following equation:${\text{Y}}_{\text{ao}} \text{=} \overline{\text{a o}} {\text{·sin (θ}}_{\text{min}} {\text{+ θ}}_{\text{s}} \text{)} {\text{= (C}}_{\text{N}} {\text{- C}}_{\text{s}} {\text{) - Y}}_{\text{ab}} {\text{= (C}}_{\text{N}} {\text{- C}}_{\text{s}} {\text{) - (C}}_{\text{N}} {\text{- C}}_{\text{min}} {\text{)·COS (θ}}_{\text{min}} {\text{+ θ}}_{\text{s}} \text{)}$

Therefore, the correction amount X_{c} in the X-axis direction can be calculated from the equation (5) by the following equation:${\text{X}}_{\text{c}} \text{=} \overline{\text{A O}} \text{=} \overline{\text{a O}} \text{=} \frac{\left({\text{C}}_{\text{N}} {\text{- C}}_{\text{s}}\right) \text{-} \left({\text{C}}_{\text{N}} {\text{- C}}_{\text{min}}\right) \text{·COS} \left({\text{θ}}_{\text{min}} {\text{+ θ}}_{\text{s}}\right)}{\text{sin} \left({\text{θ}}_{\text{min}} {\text{+ θ}}_{\text{s}}\right)}$

After the component mounting position correction amounts X_{c}, Y_{c} and θ_{c} in the X-direction, Y-direction and θ-direction, respectively, are calculated as described above, the X-axis, Y-axis and θ-axis servomotors 3, 9 and 15, respectively, are actuated, and the head unit 1 is moved according to the correction amounts X_{c}, Y_{c} and θ_{c} (step 17 in Fig. 4, 4 in Figs 5. and 6). Then, when it is confirmed that the co-ordinates (X, Y and θ) of the center point G of the component K comes in the range of the predetermined mounting position (step 18 in Fig. 4), the Z-axis servomotor 16 is actuated and the mounting nozzle 14 is lowered together with the component K (step 19 in Fig. 4, 5 in Figs. 5 and 6), then, when it is confirmed that its height has come in the predetermined range (step 20 in Fig 4), the attracting vacuum which has been applied to the attracting nozzle 14 is cut off (step 21 in Fig. 4), and the component K is mounted accurately at the specified position (6 in Figs. 5 and 6).

After the component K is mounted, the Z-axis servomotor 16 is actuated and the attracting nozzle 14 is raised (step 22 in Fig. 4), thus a series of mounting operation is performed (step 23 in Fig. 4).

In this embodiment, since the component mounting position correction amount X_{c} in the X-axis direction is obtained by calculation, using the data Cₛ, θₛ, Cₘᵢₙ and θₘᵢₙ as described above, extra time for actual measurement can be eliminated, the time required for positioning the component is shortened, and thus the component mounting efficiency is improved.

Yet, although the Y-axis direction component mounting position correction amount Y_{c} of the component K is obtained through detection of projection width W of the component K on the Y-axis, and the X-axis direction component mounting position correction amount X_{c} is obtained by calculation in the embodiment above, it is of course possible that on the contrary, the X-axis direction component mounting position correction amount X_{c} of the component K is obtained through detection of projection width of the component K on the X-axis, and the Y-axis direction component mounting position correction amount Y_{c} is obtained by calculation.

As is clear from the description above, since the Y (X) axis direction and θ direction component mounting position correction amounts of the component K are actually measured through detection of projection width of the component K on the Y (X) axis while the component is attracted and rotated in the X-Y-plane about the attracting point (R-axis) in the θ direction, and the X (Y) axis direction component mounting position correction amount is obtained by calculation on the basis of the actual measurement in the embodiment above, effects are obtained that extra time for actual measurement can be eliminated, the time required for positioning the component is shortened, and thus the component mounting efficiency is improved.

## Claims

1. Method for mounting a component (K) at a specific position, preferably on a substrate such as a printed circuit board, by means of attracting the component by an attracting nozzle (14) from a component supply unit (30), transferring the component and mounting same at the specific position, wherein a projection width (W) of the component (K) along one of the X- or Y-axis in an X-Y-plane is detected while rotating the attracting nozzle (14) in the X-Y-plane through a predetermined angle of rotation (θₑ) about its vertical axis (R) extending along the Z-axis, whereby correcting amounts (Y_{c}, θ_{c}) of the component's mounting position with respect to the rotational position of the component (K) and one of the longitudinal positions of the component (K) which is in the direction of said one axis are obtained, **characterised in that**,by said detection, a normal attracting position of the component (K) is discriminated and in that a correcting amount (X_{c}) with respect to the other longitudinal position in the direction of the other axis is obtained by calculation using data (Cₛ, θₛ, Cₘᵢₙ, θₘᵢₙ) obtained by said detection.

2. Method as claimed in claim 1, **characterised in that,** after attracting the component (K) through the attracting nozzle (14) from a feeder (31) of the component supplying unit (30), a Z-axis servomotor (16) is actuated and it is investigated whether the attracting nozzle (14) has left a range of interference with the feeder (31) and then the mounting head unit (1) is moved towards the component mounting position by actuating respective servomotor (3,9) while distances of the movement in the directions of the X-axis and Y-axis and the angle of rotation of the attracting nozzle (14) about its vertical axis (R) are detected by a position detecting means (4,13,17) and corresponding signals are fed back to an axis controlling and driving means (6) of a main control unit (5).

3. Method as claimed in claims 1 or 2, **characterised in that** the component (K) is subject to a laser beam (L) which is emitted in parallel to one of the longitudinal axes (X or Y) of the X-Y-plane while being rotated clockwise about its vertical axis (R) to detect initial start values of the projection width (Wₛ) of the component (K), a centre position (Cₛ) of the projection width (Wₛ) and a rotational angle (θₛ) of the attracting nozzle (14), said values being fed to a main processor (23) of a main control unit (5) through a laser unit processor (21) and an input-output means (22) of the main control unit (5).

4. Method as claimed in at least one of the preceding claims 1 to 3, **characterised in that** the attracting nozzle (14) with the component (K) attracted thereto is rotated counter-clockwise by a predetermined angle (θe), simultaneously detecting the projection width (W) of the component (K) on one of the longitudinal axes (X-axis or Y-axis), a minimum projection width (Wₘᵢₙ) of the component (K), the centre position (Cₘᵢₙ) of the minimum projection width (Wₘᵢₙ) and the associated minimum rotation angle (θₘᵢₙ) of the attracting nozzle (14), and in that the discrimination of the normal attracting position of the component (K) as well as the calculation of the non-measured correcting amount (X_{c}) for one of the longitudinal directions not measured is performed.

5. Apparatus for mounting a component at a specific position, preferably on a substrate such as a printed circuit board, comprising a movable mounting head unit (1) supporting an attracting nozzle (14) for attracting by vacuum a component (K) to be mounted, a component position detecting means (20) and a main control unit (5) for controlling the operation of the apparatus, preferably for performing the method according to claim 1, wherein said attracting nozzle (14) is supported rotatably about its vertical centre axis (R) extending along the Z-axis, the detecting means being an optical detecting means (20) to provide a projection of the component (K) and data relating to a detection of a projection width (W) of the component (K) along one of the X- or Y-axis in an X-Y-plane as well as to obtain mounting position correcting amounts (Y_{c}, θc) with respect to one to the longitudinal positions of the component (K) which is in the direction of said one axis and the rotational position of the component (K), **characterised in that** a processing means (23) is provided for calculating another mounting position correcting amount (X_{c}) of the component's mounting position with respect to the other longitudinal position of the component (K) in the direction of the other axis on the basis of said data (Cₛ, θₛ, Cₘᵢₙ, θₘᵢₙ) provided by said detecting means (20).

6. Apparatus as claimed in claim 5, **characterised in that**, the mounting head unit (1) is supported to be movable in a horizontal X-Y-plane.

7. Apparatus as claimed in claims 5 or 6, **characterised in that** the mounting head unit (1) is movable in the X-axis direction through a servomotor (3) having a position detecting means (4) associated thereto, and that the head unit (1) is movable in the Y-axis direction through its servomotor (9) having a position detecting means (13) associated thereto, said servomotors (3,9) and associated position detecting means (4,13) are electrically connected to an axis controlling and driving means (6) of the main control unit (5).

8. Apparatus as claimed in at least one of the preceding claims 5 to 7, **characterised in that** the attracting nozzle (14) is rotatably supported at the mounting head unit (1) through an R-axis servomotor (15) and is slideably supported to be vertically slideable along the Z-axis through a Z-axis servomotor (16), with respective position detecting means (17,18) being associated to the servomotors (15,16) said servomotors (15,16) and said position detecting means (17,18) being electrically connected to the axis controlling and driving means (6) of the main control unit (5).

9. Apparatus as claimed in at least one of the preceding claims 5 to 8, **characterised in that** a laser beam unit (20) is installed as an optical detecting means at a lower end of the mounting head unit (1), said laser beam unit (20) comprising a laser beam generator (20A) and a detector (20B) disposed opposite to each other on both sides of the attracting nozzle (14).

10. Apparatus as claimed in claim 9, **characterised in that** the laser beam unit (20) is electrically connected to a laser unit processor (21) which is connected to a main processor (23) through an input-output means (22) of the main control unit (5).

11. Apparatus as claimed in at least one of the preceding claims 5 to 10, **characterised in that** the mounting head unit (1) comprises an interference position detecting means (24) which is adapted to detect a position of interference of a component supplying unit (30) and the attracting nozzle (14), said interference position detecting means (24) being connected to the input-output means (22) of the main control unit (5).

## Patentansprüche

1. Verfahren zum Montieren eines Bauteils (K) an einer bestimmten Position, bevorzugt auf einem Substrat, wie eine gedruckte Leiterplatte, mittels Anziehen des Bauteils mit einer Anzieh-Düse (14) von einer Bauteil-Zuführungseinheit (30), Überführen des Bauteils und Montieren desselben an der bestimmten Position, wobei die Überhangweite (W) des Bauteils (K) entlang einer der X- oder Y-Achsen in der X-Y-Ebene erfaßt wird, während die Anzieh-Düse (14) in der X-Y-Ebene um einen vorbestimmten Drehwinkel (θₑ) um ihre, sich in Richtung der Z-Achse erstreckenden Vertikalachse gedreht wird, wodurch Korrekturwerte (Y_{c}, θ_{c}) für die Montierposition des Bauteils bezüglich der Drehstellung des Bauteils (K) und eine der longitudinalen Positionen, welche die Richtung dieser einen Achse ist, des Bauteils (K) erhalten werden, **dadurch gekennzeichnet**, daß bei dieser Erfassung eine normale Anzieh-Position diskriminiert wird und daß ein Korrekturwert (X_{c}) bezüglich der anderen longitudinalen Position in Richtung der anderen Achse erhalten wird durch Berechnen unter Verwendung von Daten (Cₛ, θₛ, Cₘᵢₙ, θₘᵢₙ)), die bei dieser Erfassung erhalten werden.

2. Verfahren nach Anspruch 1, **dadurch gekennzeichnet**, daß nach dem Anziehen des Bauteils (K) durch die Anzieh-Düse (14) aus einem Zufuhrapparat (31) der Bauteilzuführungseinheit (30) ein Z-Achsen-Servomotor (16) betätigt und untersucht wird, ob die Anzieh-Düse (14) einen Überlagerungsbereich mit dem Zufuhrapparat (31) verlassen hat, und anschließend die Montierkopfeinheit (1) in Richtung der Bauteilmontageposition bewegt wird durch Betätigen entsprechender Servomotoren (3, 9), während die Bewegungsabstände in Richtung der X-Achse und der Y-Achse und der Drehwinkel der Anzieh-Düse (14) um ihre Vertikalachse (R) von einer Positionserfassungseinrichtung (4, 13, 17) erfaßt und entsprechende Signale an eine Achsensteuer- und Antriebseinrichtung (6) einer Hauptsteuereinheit (5) rückgeführt werden.

3. Verfahren nach Anspruch 1 oder 2, **dadurch gekennzeichnet**, daß das Bauteil (K) mit einem Laserstrahl (L) beaufschlagt wird, welcher parallel zu einer der longitudinalen Achsen (X oder Y) der X-Y-Ebene emittiert wird, während es in Uhrzeigerrichtung um seine Vertikalachse (R) gedreht wird, um Eingangsstartwerte der Überhangsweite (Wₛ) des Bauteils (K), eine Mittenposition (Cₛ) der Überhangsweite (Wₛ) und einen Drehwinkel (θₛ) der Anzieh-Düse (14) zu erfassen, und diese Werte einer Hauptverarbeitungseinheit (23) einer Hauptsteuereinheit (5) durch eine Lasereinheit-Verarbeitungseinheit (21) und eine Eingabe-Ausgabe-Einrichtung (22) der Hauptsteuereinheit (5) rückgeführt werden.

4. Verfahren nach mindestens einem der vorstehenden Ansprüche 1 bis 3, **dadurch gekennzeichnet**, daß die Anzieh-Düse (14) mit dem daran anhaftenden Bauteil (K) entgegen dem Uhrzeigersinn um einen vorbestimmten Winkel (θe) gedreht wird, wobei gleichzeitig die Überhangsweite (W) des Bauteils (K) auf einer der longitudinalen Achsen (X-Achse oder Y-Achse), eine Minimumüberhangsweite (Wₘᵢₙ) des Bauteils (K), die Mittenposition (Cₘᵢₙ) der Minimumüberhangsweite (Wₘᵢₙ) und der dazugehörige Minimumdrehwinkel (θₘᵢₙ) der Anziehdüse (14) erfaßt werden, und sowohl die Diskriminierung der normalen Anzieh-Position des Bauteils (K) als auch die Berechnung der nicht gemessenen Korrekturgröße (X_{c}) für eine der nicht gemessenen longitudinalen Richtungen durchgeführt wird.

5. Vorrichtung zum Montieren eines Bauteils an einer bestimmten Position, bevorzugt auf einem Substrat, wie eine gedruckte Leiterplatte, mit einer eine Anzieh-Düse (14) halternden, bewegbaren Montierkopfeinheit (1) zum Anziehen eines zu montierenden Bauteils (K) mittels Vakuum, einer Bauteilpositionserfassungseinrichtung (20) und einer Hauptsteuereinheit (5) zur Steuerung des Betriebs der Vorrichtung, bevorzugt zur Durchführung des Verfahrens nach Anspruch 1, wobei die Anzieh-Düse (14) drehbar um ihre vertikale Mittelachse (R), die sich entlang der Z-Achse erstreckt, gelagert ist, die Erfassungseinrichtung eine optische Erfassungseinrichtung (20) ist, um sowohl eine Projektion des Bauteils (K) und Daten bezüglich einer Erfassung einer Projektionsweite (W) des Bauteils (K) entlang einer der X- oder Y-Achsen in der X-Y-Ebene zur Verfügung zu stellen als auch Korrekturgrößen (Y_{c}, θc) bezüglich einer der longitudinalen Positionen des Bauteils (K) zu erhalten, welche die Richtung dieser einen Achse und die Drehposition des Bauteils (K) sind, **dadurch gekennzeichnet,** daß eine Verarbeitungseinrichtung (23) vorgesehen ist zur Berechnung einer anderen Montageposition-Korrekturgröße (X_{c}) für die Montageposition des Bauteils bezüglich der anderen longitudinalen Position des Bauteils (K) in Richtung dieser anderen Achse auf der Grundlage der Daten (Cₛ, θₛ, Cₘᵢₙ, θₘᵢₙ), die von der Erfassungseinrichtung (20) vorliegen.

6. Vorrichtung nach Anspruch 5, **dadurch gekennzeichnet,** daß die Montierkopfeinheit (1) in einer horizontalen X-Y-Ebene bewegbar gelagert ist.

7. Vorrichtung nach Anspruch 5 oder 6, **dadurch gekennzeichnet**, daß die Montierkopfeinheit (1) in X-Achsen-Richtung bewegbar ist mittels eines Servomotors (3) mit einer dazugeordneten Positionserfassungseinrichtung (4), und daß die Kopfeinheit (1) in Y-Achsen-Richtung bewegbar ist mittels ihres Servomotors (9) mit einer dazugeordneten Positionserfassungseinrichtung (13), wobei diese Servomotoren (3, 9) und die dazugeordneten Positionserfassungseinrichtungen (4, 13) elektrisch an einer Achsensteuer- und Antriebseinrichtung (6) der Hauptsteuereinheit (5) angeschlossen sind.

8. Vorrichtung nach mindestens einem der vorstehenden Ansprüche 5 bis 7, **dadurch gekennzeichnet**, daß die Anzieh-Düse (14) an der Montierkopfeinheit (1) durch einen R-Achsen-Servomotor (15) drehbar gelagert und gleitbar gelagert ist, um vertikal entlang der Z-Achse durch einen Z-Achsen-Servomotor (16) vertikal verschiebbar zu sein, wobei entsprechende Positionserfassungseinrichtungen (17, 18) diesen Servomotoren (15, 16) zugordnet sind und diese Servomotoren (15, 16) und diese Positionserfassungseinrichtungen (17, 18) elektrisch mit der Achsensteuer- und Antriebseinheit (6) der Hauptsteuereinheit (5) verbunden sind.

9. Vorrichtung nach mindestens einem der vorstehenden Ansprüche 5 bis 8, **dadurch gekennzeichnet**, daß eine Laserstrahleinheit (20) als optische Erfassungseinrichtung am unteren Ende der Montierkopfeinheit (1) befestigt ist, wobei diese Laserstrahleinheit (20) einen Laserstrahlgenerator (20A) und einen Detektor (20B) enthält, die einander gegenüberliegend zu beiden Seiten der Anzieh-Düse (14) angeordnet sind.

10. Vorrichtung nach Anspruch 9, **dadurch gekennzeichnet,** daß die Laserstrahleinheit (20) elektrisch mit einer Lasereinheit-Verarbeitungseinheit (21) verbunden ist, welche an einer Hauptverarbeitungseinheit (23) über eine Eingabe-Ausgabe-Einrichtung (22) der Hauptsteuereinheit (5) angeschlossen ist.

11. Vorrichtung nach zumindestens einem der vorstehenden Ansprüche 5 bis 10, **dadurch gekennzeichnet,** daß die Montierkopfeinheit (1) eine Überlagerungsposition-Erfassungseinrichtung (24) enthält, welche dazu geeignet ist, eine Überlagerungsposition einer Bauteilzuführungseinheit (30) und der Anzieh-Düse (14) zu erfassen, wobei diese Überlagerungsposition-Erfassungseinrichtung (24) an der Eingabe-Ausgabe-Einrichtung (22) der Hauptsteuereinheit (5) angeschlossen ist.

## Revendications

1. Procédé pour monter un composant (K) en une position spécifique, de préférence sur un substrat telle qu'une plaquette de circuit imprimé, au moyen de l'attraction du composant par une buse d'attraction (14) depuis un agencement d'amenée de composant (30), transférer le composant et monter ce dernier dans la position spécifique, dans laquelle une largeur de saillie (W) du composant (K) le long de l'axe X ou Y dans un plan X-Y est détectée tout en faisant tourner la buse d'attraction (14) dans le plan X-Y d'un angle prédéterminé de rotation (θₑ) autour de son axe vertical (R) s'étendant le long de l'axe Z, de manière que des valeurs de correction (Y_{c}, θ_{c}) de la position de montage du composant par rapport à la position de rotation du composant (K) et l'une des positions longitudinales du composant (K) qui se situe dans la direction dudit premier axe soient obtenues, caractérisé en ce que, par ladite détection, une position d'attraction normale du composant (K) est déterminée par discrimination et en ce qu'une valeur de correction (X_{c}) par rapport à l'autre position longitudinale dans la direction de l'autre axe est obtenue par un calcul à l'aide de données (Cₛ, θₛ, Cₘᵢₙ, θₘᵢₙ) obtenues par ladite détection.

2. Procédé selon la revendication 1, caractérisé en ce que, après l'attraction du composant (K) via la buse d'attraction (14) depuis un organe d'amenée (31) de l'agencement d'amenée de composant (30), un servomoteur d'axe Z (16) est actionné et il est déterminé si la buse d'attraction (14) a laissé une plage d'interférence avec l'organe d'amenée (31) et l'agencement de tête de montage (1) est alors déplacé vers la position de montage de composant en actionnant le servomoteur (3, 9) respectif, tandis que des distances du mouvement dans les directions de l'axe X et de l'axe Y et l'angle de rotation de la buse d'attraction (14) autour de son axe vertical (R) sont mesurées par un moyen de détection de position (4, 13, 17) et des signaux correspondants sont amenés en retour à un moyen de commande et d'entraînement d'axe (6) d'une unité de commande principale (5).

3. Procédé selon la revendication 1 ou 2, caractérisé en ce que le composant (K) est exposé à un faisceau laser (L) qui est émis parallèlement à l'un des axes longitudinaux (X ou Y) du plan X-Y, tout en étant entraîné en rotation dans le sens des aiguilles d'une montre autour de son axe vertical (R) pour mesurer des valeurs de départ initiales de largeur de saillie (Wₛ) du composant (K), une position centrale (Cₛ) de la largeur de saillie (Wₛ) et un angle de rotation (θₛ) de la buse d'attraction (14), lesdites valeurs étant amenées à un processeur principal (23) d'une unité de commande principale (5) via un processeur d'unité laser (21) et un moyen d'entrée/sortie (22) de l'unité de commande principale (5).

4. Procédé selon au l'une des revendications 1 à 3 précédentes, caractérisé en ce que la buse d'attraction (14) ainsi que le composant (K) attiré par cette dernière sont entraînés en rotation dans le sens contraire des aiguilles d'une montre d'un angle prédéterminé (θₑ), en mesurant simultanément la largeur de saillie (W) du composant (K) sur l'un des axes longitudinaux (axe X ou axe Y), une largeur de saillie (Wₘᵢₙ) minimale du composant (K), la position centrale (Cₘᵢₙ) de la largeur de saillie (Wₘᵢₙ) minimale et l'angle de rotation (θₘᵢₙ) minimal associé de la buse d'attraction (14), et en ce que la discrimination de la position d'attraction normale du composant (K), ainsi que le calcul de la valeur de correction (X_{c}) non mesurée pour l'une des directions longitudinales non mesurées sont effectués.

5. Appareil pour monter un composant en une position spécifique, de préférence sur un substrat tel qu'une plaquette de circuit imprimé, comprenant un agencement de tête de montage (1) déplaçable supportant une buse d'attraction (14) pour attirer par aspiration un composant (K) devant être monté, un moyen de détection de position de composant (20) et une unité de commande principale (5) pour commander le fonctionnement de l'appareil, de préférence pour exécuter le procédé selon la revendication 1, dans lequel ladite buse d'attraction (14) est montée tournante autour de son axe central vertical (R) s'étendant le long de l'axe Z, le moyen de détection étant un moyen de détection optique (20) pour fournir une saillie du composant (K) et des données concernant la mesure d'une largeur de saillie (W) du composant (K) de long de l'axe X ou Y dans un plan X-Y, ainsi que pour obtenir des valeurs de correction de position de montage (Y_{c}, θ_{c}) par rapport à l'une des positions longitudinales du composant (K), qui se situe dans la direction dudit premier axe, et la position de rotation du composant (K), caractérisé en ce qu'un moyen de traitement (23) est prévu pour calculer une autre valeur de correction de position de montage (X_{c}) de la position de montage du composant par rapport à l'autre position longitudinale du composant (K) dans la direction de l'autre axe, d'après lesdites données (Cₛ, θₛ, Cₘᵢₙ, θₘᵢₙ) fournies par ledit moyen de détection (20).

6. Appareil selon la revendication 5, caractérisé en ce que l'agencement de tête de montage (1) est supporté de façon à être déplaçable dans un plan X-Y horizontal.

7. Appareil selon la revendication 5 ou 6, caractérisé en ce que l'agencement de tête de montage (1) est déplaçable dans la direction de l'axe X via un servomoteur (3) ayant un moyen de détection de position (4) lui étant associé, et en ce que l'agencement de tête (1) est déplaçable dans la direction de l'axe Y via son servomoteur (9), ayant un moyen de détection de position (13) lui étant associé, lesdits servomoteurs (3, 9) et le moyen de détection de position (4, 13) associé étant connectés électriquement à un moyen de commande et d'entraînement d'axe (6) de l'unité de commande principale (5).

8. Appareil selon au l'une des revendications 5 à 7 précédentes, caractérisé en ce que la buse d'attraction (14) est montée tournante sur l'agencement de tête de montage (1), via un servomoteur d'axe R (15) et est montée coulissante pour pourvoir coulisser verticalement le long de l'axe Z via un servomoteur d'axe Z (16), un moyen de détection de position (17, 18) respectif étant associé aux servomoteurs (15, 16), lesdits servomoteurs (15, 16) et lesdits moyens de détection de position (17, 18) étant connectés électriquement au moyen de commande et d'entraînement d'axe (6) de l'unité de commande principale (5).

9. Appareil selon au moins l'une des revendications 5 à 8 précédentes, caractérisé en ce qu'une unité de faisceau laser (20) est installée à titre de moyen de détection optique à une extrémité inférieure de l'agencement de tête de montage (1), ladite unité de faisceau laser (20) comprenant un générateur de faisceau laser (20A) et un détecteur (20B) disposés à l'opposé l'un de l'autre des deux côtés de la buse d'attraction (14).

10. Appareil selon la revendication 9, caractérisé en ce que l'unité de faisceau laser (20) est connectée électriquement à un processeur d'unité laser (21) qui est connecté à un processeur principal (23), via un moyen d'entrée/sortie (22) de l'unité de commande principale (5).

11. Appareil selon au moins l'une des revendications 5 à 10 précédentes, caractérisé en ce que l'agencement de tête de montage (1) comprend un moyen de détection de position d'interférence (24) qui est adapté pour détecter une position d'interférence d'un agencement d'amenée de composant (30) et de la buse d'attraction (14), ledit moyen de détection de position d'interférence (24) étant connecté au moyen d'entrée/sortie (22) de l'unité de commande principale (5).
